# EUROPEAN PATENT APPLICATION

(11) **EP 4 672 334 A1**
(43) Date of publication of application: **31.12.2025**
(21) Application number: 25177094.7
(22) Date of filing: 16.05.2025
(51) Int. Cl.: H01L 23/498, H01L 23/538, H01L 25/065

(54) **ORGANIC INTERPOSER WITH INORGANIC LAYERS CONTAINING PASSIVE AND/OR ACTIVE DEVICES**

(30) Priority: 27.06.2024 US 202418757315
(71) Applicant: INTEL Corporation, Santa Clara, CA 95054 (US)
(72) Inventor: ALEKSOV, Aleksandar, Chandler, AZ 85286 (US); SWAN, Johanna M., Scottsdale, AZ 85255 (US)
(74) Representative: HGF

(57) **Abstract**

Embodiments disclosed herein include an apparatus with a first layer, where the first layer is a first inorganic material. The apparatus may also include a second layer over the first layer, where the second layer is a second inorganic material. In an embodiment, the second layer includes an active electrical device or a passive electrical device. In an embodiment, the apparatus further includes a third layer over the second layer, where the third layer is an organic buildup film. In an embodiment, the passive electrical device or the active electrical device is electrically coupled to one or more electrically conductive traces embedded in the third layer.

## Description

### BACKGROUND

Organic interposers created by wafer-level or panel-level processing are cost-efficient options to provide die-to-die interposers and enable heterogeneous integration, especially for large-area systems. However, organic interposers are unable to integrate passive devices and active devices during manufacture. Accordingly, from a capability and versatility perspective, organic interposers are at an application disadvantage to silicon interposers which can include integrated active and/or passive devices. Despite having the ability to integrate passive devices and active devices, silicon interposers are limited by higher costs and poor power delivery performance due to the need for through silicon vias (TSVs).

### BRIEF DESCRIPTION OF THE DRAWINGS

Figure 1 is a cross-sectional illustration of an electronic system that comprises a hybrid interposer with inorganic layers and organic layers, in accordance with an embodiment.
Figure 2A is a cross-sectional illustration of an electronic system with a hybrid interposer with a plurality of inorganic layers with integrated active and/or passive devices and overlying organic layers for electrical routing, in accordance with an embodiment.
Figure 2B is a cross-sectional illustration of an electronic system with a hybrid interposer with a layer transferred inorganic layer with integrated active and/or passive devices and overlying organic layers for electrical routing, in accordance with an embodiment.
Figure 2C is a cross-sectional illustration of an electronic system with a hybrid interposer with a plurality of layer transferred inorganic layers with integrated active and/or passive devices and overlying organic layers for electrical routing, in accordance with an embodiment.
Figures 3A - 3J are cross-sectional illustrations that depict a process for manufacturing an electronic system with a hybrid interposer with inorganic layers and organic layers, in accordance with an embodiment.
Figure 4 is a flow diagram of a process for manufacturing an electronic system with a hybrid interposer with inorganic layers and organic layers, in accordance with an embodiment.
Figures 5A- 5H are cross-sectional illustrations that depict a process for manufacturing an electronic system with a hybrid interposer with inorganic layers provided with a layer transfer process and organic layers, in accordance with an embodiment.
Figures 6A - 6H are cross-sectional illustrations that depict a process for manufacturing an electronic system with a hybrid interposer with inorganic layers provided with a layer transfer process and organic layers, in accordance with an embodiment.
Figures 7A - 7C are cross-sectional illustrations that depict a portion of a process for manufacturing a hybrid interposer with a via first process, in accordance with an embodiment.
Figure 8 is a flow diagram of a process for manufacturing an electronic system with a hybrid interposer with inorganic layers provided with a layer transfer process and organic layers, in accordance with an embodiment.
Figure 9 is a cross-sectional illustration of an electronic system with a hybrid interposer with inorganic layers and organic layers, in accordance with an embodiment.
Figure 10 is a schematic of a computing device built in accordance with an embodiment.

### EMBODIMENTS OF THE PRESENT DISCLOSURE

Described herein are package architectures with hybrid interposers that include inorganic layers that comprise passive and/or active devices and organic layers over the inorganic layers, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

As noted above, existing interposer solutions include either organic interposers or silicon interposers. Each options has different tradeoffs. Organic interposers are more cost-effective, but are limited in the ability to integrate passive devices and/or active devices into the interposer. As such, the organic interposers are functionality limited. Silicon interposers are more expensive than organic interposers, but have the ability to integrate passive devices and/or active devices into the manufacturing flow. Silicon interposers may also allow for higher density interconnects for die-to-die assembly. However, silicon interposers may require dual-damascene based copper interconnect layers and through silicon vias (TSVs). Such processes make manufacturing silicon interposers expensive, and the TSVs may negatively impact power delivery performance. The cost quickly increases for large area systems, such as those used for artificial intelligence (AI) applications or high performance computing (HPC) applications.

Accordingly, embodiments disclosed herein comprise hybrid interposers that combine the benefits of silicon based interposers with the cost-effectiveness of organic interposers. For example, the hybrid interposer may comprise a first strata that comprises one or more inorganic layers. The passive devices and/or active devices may be integrated into the inorganic layers of the first strata in order to provide the desired functionality for the hybrid interposer. Integrated passive devices may include capacitors (e.g., metal-insulator-metal (MIM) capacitors), inductors, resistors, or the like. Integrated active devices may include transistors, diodes, or the like. In some embodiments, passive devices and/or active devices may be coupled together in order to provide more complex structures such as memory cells, complementary metal-oxide semiconductor (CMOS) cells, electrostatic discharge (ESD) devices, power delivery (PD) circuitry, RF circuitry, and/or the like. A second strata may comprise one or more organic dielectric layers. The organic dielectric layers may include electrical routing in order to provide electrical coupling between the passive devices and/or active devices and the dies that are attached to the hybrid interposer.

In one embodiment, the first strata with the inorganic layers and electrical interconnects are formed with a damascene process or a semi-additive process (SAP). The integration of passive devices and/or active devices may be done along with the formation of the multiple inorganic layers. For example, MIM capacitor structures may be formed on and/or in one or more of the inorganic layers of the first strata. While semiconductor materials may not be present in such an embodiment, transistors, diodes, and structures formed from transistors and/or diodes may be manufactured with thin film processes. For example, thin films comprising one or more of indium, gallium, zinc, or oxygen (e.g., IGZO or IZO) can be formed on and/or in one or more of the inorganic layers in order to form active devices.

In another embodiment, the first strata may comprise a first inorganic layer. The inorganic layer may serve as a base on which subsequent layers can be applied. Particularly, a layer transfer process may be used to apply a second layer over the first inorganic layer. The use of a layer transfer process allows for a wider selection of materials to be integrated into the first strata. For example, the second layer may comprise a semiconductor material, such as silicon, gallium nitride (GaN), or any other III-V semiconductor material. As such, transistor and/or diode devices with improved performance compared to those based on thin film structures can be integrated into the first strata.

In yet another embodiment, the first strata may comprise a first inorganic layer. The inorganic layer may serve as a base on which subsequent layers can be applied. Particularly, a plurality of layer transfer processes may be used to apply a plurality of second layers over the first inorganic layer. Similar to above, the layer transfer process allows for greater flexibility in the selection of the passive devices and/or active devices that are integrated into the first strata. Further, the multiple layer transfer processes allow for any desired capacity for the passive devices and/or active devices.

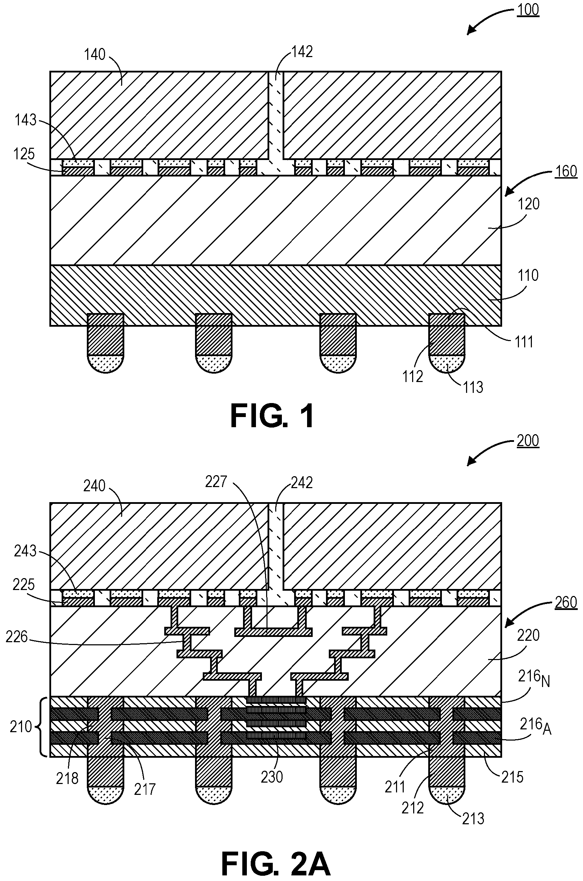

Referring now to Figure 1, a cross-sectional illustration of an electronic system 100 is shown, in accordance with an embodiment. In an embodiment, the electronic system 100 may comprise an interposer 160. The interposer 160 may be a hybrid interposer 160. That is, the interposer 160 may comprise at least a first strata 110 and a second strata 120. In an embodiment, the first strata 110 may comprise one or more inorganic dielectric layers (not individually shown) and the second strata 120 may comprise one or more organic dielectric layers (not individually shown). The inorganic dielectric layers of the first strata 110 may comprise any suitable inorganic dielectric, such as one comprising silicon and oxygen (e.g., SiO_{X}), silicon and nitrogen (e.g., SiN_{X}), silicon, oxygen, and nitrogen (e.g., SiO_{X}N_{Y}), silicon, carbon, and nitrogen (SiCN), or the like. The inorganic layers of the first strata 110 may also comprise semiconductor material, such as silicon, gallium and nitrogen (GaN), or any group III-V semiconductor. The organic dielectric layers may comprise a polymer based dielectric, such as a polyimide, benzocyclobutene (BCB), epoxy, or the like. The organic dielectric layers may also comprise an organic matrix with inorganic filler particles such as, silica, SiC, SiN_{X}, SiO_{X}, SiCN, or the like.

In an embodiment, the first strata 110 may comprise one or more active electrical devices (also referred to as active devices for short) and/or one or more passive electrical devices (also referred to as passive devices for short). The active and/or passive devices are omitted from Figure 1 for clarity. Active devices may comprise transistors, diodes, or the like. In some embodiments, active devices may be coupled together to form more complex structures, such as memory cells, CMOS cells, ESD devices, PD circuitry, RF circuitry, and/or the like. Passive device may comprise capacitors (e.g., MIM capacitors), inductors, resistors, and/or the like.

In an embodiment, the second strata 120 may comprise electrical routing (not shown in Figure 1) to electrically couple the active devices and/or passive devices to the one or more dies 140 that are coupled to the interposer 160. The second strata 120 may also comprise electrical routing to provide die-to-die interconnects between dies 140. In an embodiment, the dies 140 may be coupled to the interposer 160 through any suitable first level interconnect (FLI) architecture. For example, solder 143 may couple the dies 140 to pads 125 on the second strata 120. Though, the dies 140 may also be hybrid bonded to the second strata 120 in some embodiments. The dies 140 may be overmolded with a mold layer 142. In the illustrated embodiment, a set of two dies 140 are shown as one example. However, it is to be appreciated that the interposer 160 may accommodate any number of dies 140, such as for accommodating large area solutions for AI and/or HPC applications.

In an embodiment, the first strata 110 may comprise pads 111 that are coupled to second level interconnect (SLI) structures. For example, the SLI structures may include a copper bump 112 and a solder 113. Though, other SLI structures (e.g., pins, sockets, etc.) may also be used to couple the first strata 110 to an underlying substrate (not shown), such as a board or the like.

Referring now to Figures 2A - 2C, a series of cross-sectional illustrations depicting a more detailed illustration of electrical systems 200 is shown, in accordance with different embodiments. In Figures 2A - 2C, the general structures of the electrical systems 200 are similar, with the exception of the configuration of the first strata 210.

Referring now to Figure 2A, a cross-sectional illustration of an electronic system 200 is shown, in accordance with an embodiment. In an embodiment, the electronic system 200 comprises an interposer 260 with a first strata 210 and an overlying second strata 220. One or more dies 240 may be coupled to the interposer 260 by solder 243 over pads 225 of the second strata 220. The dies 240 may be embedded in a mold layer 242 in some embodiments.

In an embodiment, the second strata 220 may comprise one or more organic dielectric layers (not individually shown), such as any of the organic dielectric materials described in greater detail herein. The organic dielectric layers may include electrical routing 226 that provides electrical coupling between one or more devices 230 that are integrated into the first strata 210 and the dies 240. The devices 230 may include active devices and/or passive devices, such as any of those described in greater detail herein. In an embodiment, the one or more dies 240 may be electrically coupled to each other through electrical routing 227 that is provided in one or more of the organic dielectric layers of the second strata 220.

In an embodiment, the first strata 210 may comprise a first layer 215 and one or more second layers 216_{A} - 216_{N}. The first layer 215 and the one or more second layers 216 may comprise inorganic dielectric material, such as any of the inorganic materials described in greater detail herein. In an embodiment, the first layer 215 may comprise pads 211 for coupling SLI interconnects, such as bumps 212 (e.g., copper bumps 212) and solder 213. Pads 218, vias 217, and/or traces (not shown) may be provided in the one or more second layers 216_{A} - 216_{N}.

In an embodiment, one or more devices 230 may be integrated in and/or provided on one or more of the first layer 215 and/or the second layers 216. The devices 230 may be manufactured on the interposer 260 during the formation of the first layer 215 and/or the second layers 216. In some embodiments, the devices 230 may comprise active devices and/or passive devices. In the case of active devices 230, the devices 230 may include transistors and/or diodes formed from thin film structures, such as those based on IGZO and/or IZO. In a particular embodiment, the devices 230 comprise MIM cap structures. The number of second layers 216 may be chosen in order to provide the necessary room (in the vertical direction) to provide a desired total capacitance for the interposer 260. In the illustrated embodiment, the devices 230 are isolated from each other. Though, it is to be appreciated that vias and/or other electrical routing may be provided through the first layer 215 and/or one or more of the second layers 216 in order to electrically couple devices 230 together.

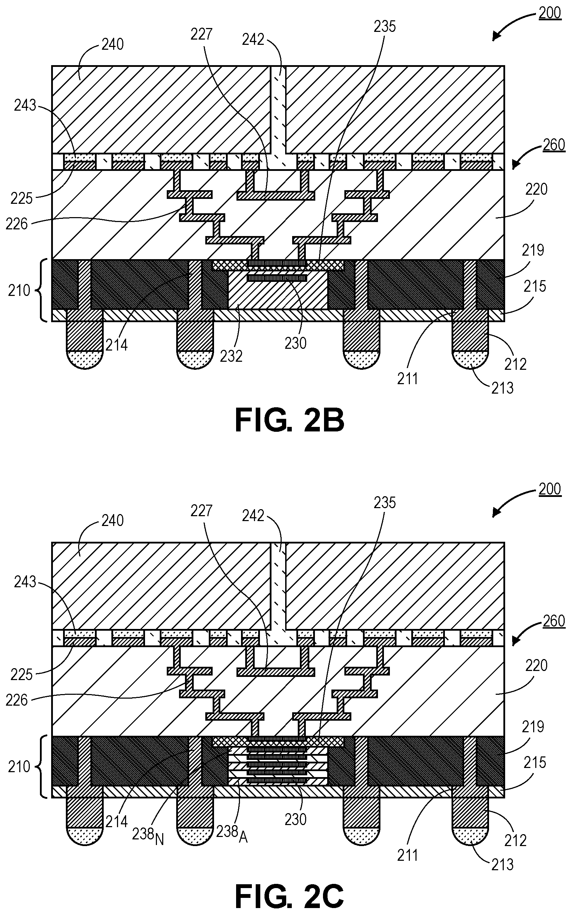

Referring now to Figure 2B, a cross-sectional illustration of an electronic system 200 is shown, in accordance with an additional embodiment. In an embodiment, the electronic system 200 in Figure 2B is similar to the electronic system 200 in Figure 2A, with the exception of the first strata 210. Instead of a plurality second layers 216 over the first layer 215, a transfer layer 232 is provided over the first layer 215. In an embodiment, the transfer layer 232 may comprise an inorganic material, such as an inorganic dielectric or a semiconductor material. As will be described in greater detail herein, the transfer layer 232 may be applied over the first layer 215 using a selective layer transfer process. The transfer layer 232 may be a monolithic structure (e.g., a single layer), or the transfer layer 232 may comprise a plurality of sub-layers.

In an embodiment, one or more devices 230 are integrated into and/or on the transfer layer 232. The devices 230 may comprise passive devices 230 and/or active devices 230. In embodiments where the transfer layer 232 comprises a semiconductor material, active devices 230 may perform better than those formed using thin-film technologies. The transfer layer 232 may include any number of devices 230 in order to provide a desired capacity. For example, a desired capacitance may be obtained by integrating a plurality of MIM capacitor devices 230 into the transfer layer 232. While referred to as a transfer layer 232, it is to be appreciated that a footprint of the transfer layer 232 may be smaller than the footprint of the underlying first layer 215. For example, Figure 2B shows that a width of the first layer 215 is greater than a width of the transfer layer 232.

In some embodiments, an additional layer 235 may be provided over the transfer layer 232. The additional layer 235 may also be an inorganic material. In some embodiments, the additional layer 235 may be a different inorganic material than the transfer layer 232. For example, the transfer layer 232 may comprise an inorganic dielectric material, such as SiO₂, and the additional layer 235 may comprise a semiconductor material. The additional layer 235 may also comprise one or more devices 230. While no electrical routing is shown within the transfer layer 232 or the additional layer 235, one or both of the additional layer 235 or the transfer layer 232 may comprise pads, traces, vias, or the like for electrically coupling devices 230 to other structures.

In an embodiment, a third layer 219 may be provided over the first layer 215. The third layer 219 may at least partially embed the transfer layer 232 and the additional layer 235. The third layer 219 may comprise an inorganic material in some embodiments. Though, in other embodiments, the third layer 219 may comprise an organic dielectric material. For example, a photoimageable dielectric (PID) may be used as the third layer 219 in some embodiments. That is, at least some portions of the first strata 210 may comprise an organic material in some embodiments. In an embodiment, vias 214 may be formed through a thickness of the third layer 219. The vias 214 may be adjacent to a sidewall of the transfer layer 232 and the additional layer 235.

Referring now to Figure 2C, a cross-sectional illustration of an electronic system 200 is shown, in accordance with an additional embodiment. In an embodiment, the electronic system 200 in Figure 2C is similar to the electronic system 200 in Figure 2B, with the exception of the first strata 210. Instead of a single transfer layer 232, a plurality of sub-layers 238_{A} - 238_{N} are provided over the first layer 215. The sub-layers 238 may comprise an inorganic material, such as an inorganic dielectric or a semiconductor material. As will be described in greater detail herein, the sub-layers 238 may be applied with selective layer transfer processes.

In an embodiment, one or more of the sub-layers 238 may each include one or more devices 230. In an embodiment, the devices 230 may include passive devices and/or active devices similar to any of the passive devices or active devices described in greater detail herein. While no electrical routing is shown within the sub-layers 238 or the additional layer 235, one or both of the additional layer 235 or the sub-layers 238 may comprise pads, traces, vias, or the like for electrically coupling devices 230 to other structures.

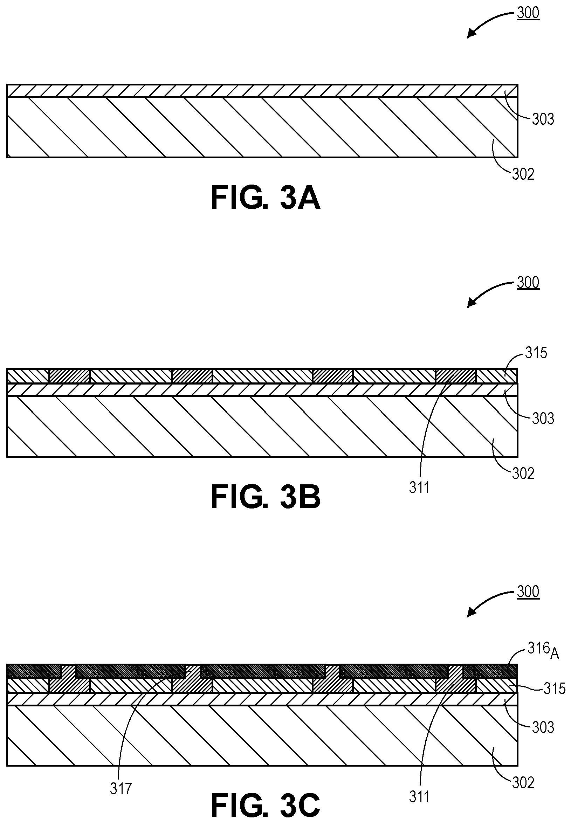

Referring now to Figures 3A - 3J, a series of cross-sectional illustrations depicting a process for forming an electronic system 300 is shown, in accordance with an embodiment. In an embodiment, the electronic system 300 in Figures 3A - 3J may be similar to the electronic system 200 shown in Figure 2A.

Referring now to Figure 3A, a cross-sectional illustration of the electronic system 300 at a stage of manufacture is shown, in accordance with an embodiment. As shown, the electronic system 300 comprises a carrier 302. The carrier 302 may be any material that is flat and rigid. For example, the carrier 302 may comprise silicon, glass, or the like. In an embodiment, a release layer 303 (or multiple release layers 303) are applied over the carrier 302. The release layer 303 may be deactivated (in order to release an overlying structure) by any suitable stimulus. The stimulus may include infrared (IR) radiation, ultraviolet (UV) radiation, or the like.

Referring now to Figure 3B, a cross-sectional illustration of the electronic system 300 after a first layer 315 is formed over the release layer 303 is shown, in accordance with an embodiment. In an embodiment, the first layer 315 may comprise an inorganic dielectric material, such as any of those described in greater detail herein. In an embodiment, pads 311 may be formed into the first layer 315. The first layer 315 and the pads 311 may be formed with a damascene process, an SAP technique, or the like.

Referring now to Figure 3C, a cross-sectional illustration of the electronic system 300 after a second layer 316_{A} is applied over the first layer 315 is shown, in accordance with an embodiment. In an embodiment, the second layer 316_{A} comprises an inorganic dielectric material, such as any of those described in greater detail herein. Vias 317 may also be fabricated through the second layer 316_{A}. In an embodiment, one or more devices (not shown), such as an active device and/or a passive devices is integrated into the second layer 316_{A} during fabrication, or the one or more devices are formed above the second layer 316_{A}. The devices may include any type of active and/or passive device described in greater detail herein. However, transistors and/or diodes may be fabricated as part of thin-film devices (e.g., based on IGZO, IZO, or the like).

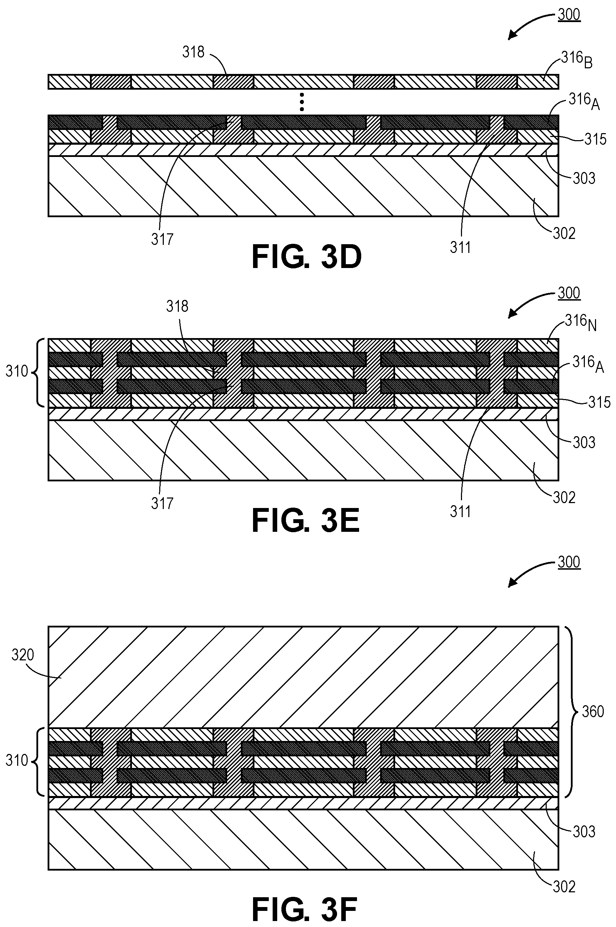

Referring now to Figure 3D, a cross-sectional illustration of the electronic system 300 during the addition of another second layer 316_{B} is shown, in accordance with an embodiment. The second layer 316_{B} may be an inorganic dielectric material. In some embodiments, the second layer 316_{A} and the second layer 316_{B} may comprise the same material. The second layer 316_{B} may be applied with any suitable deposition process. Pads 318 may be formed with a patterning and deposition process. A device (not shown) may also be integrated into and/or provided on the second layer 316_{B}.

Referring now to Figure 3E, a cross-sectional illustration of the electronic system 300 after a plurality of second layers 316_{A} - 316_{N} have been formed over the first layer 315 is shown, in accordance with an embodiment. The number of second layers 316 may be chosen in order to provide the sufficient density of passive devices and/or active devices. For example, when the devices are MIM capacitors, a number of second layers 316 may be chosen in order to provide enough room for the desired capacitance density of the electronic system 300.

As indicated in Figure 3E, the first layer 315 and the plurality of second layers 316_{A} - 316_{N} may be referred to as being the first strata 310. In such an embodiment, the individual layers of the first strata 310 may each comprise an inorganic dielectric material. The first strata 310 may comprise any number of pads 311 in the first layer 315, vias 317 through second layers 316, or pads 318 within second layers 316. The first strata 310 may also comprise any number of active devices and/or passive devices.

Referring now to Figure 3F, a cross-sectional illustration of the electronic system 300 after a second strata 320 is formed over the first strata 310 is shown, in accordance with an embodiment. In an embodiment, the second strata 320 may comprise organic dielectric material, such as any of the organic dielectric material described in greater detail herein. While shown as a single monolithic layer, it is to be appreciated that the second strata 320 may comprise a plurality of organic dielectric layers. Additionally, electrical routing (e.g., pads, traces, vias, etc.) may be provided in the second strata 320, similar to the embodiment shown in Figure 2A. As illustrated, the combination of the first strata 310 and the second strata 320 may be referred to as an interposer 360. More particularly, the interposer 360 may be a hybrid interposer 360.

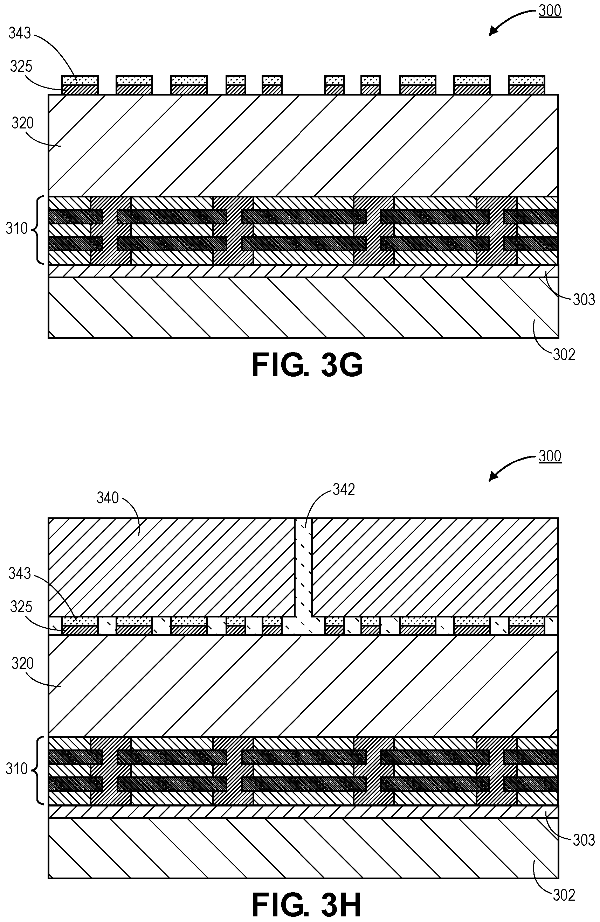

Referring now to Figure 3G, a cross-sectional illustration of the electronic system 300 after interconnects are provided over the second strata 320 is shown, in accordance with an embodiment. In an embodiment, the interconnects may comprise pads 325 on the second strata 320 and solder 343 that is provided over the pads 325. Though, it is to be appreciated that other types of interconnect architectures may be used.

Referring now to Figure 3H, a cross-sectional illustration of the electronic system 300 after dies 340 are attached to the second strata 320 is shown, in accordance with an embodiment. In an embodiment, the dies 340 may include any type of die, such as a processor, a memory, a communications die, and/or the like. In an embodiment, a mold layer 342 may be used to encapsulate the dies 340. While two dies 340 are shown in Figure 3H, it is to be appreciated that any number of dies may be coupled to the second strata 320. In an embodiment, the two dies 340 may be electrically coupled to each other by electrical routing (not shown) within the second strata 320, similar to the embodiment shown in Figure 2A.

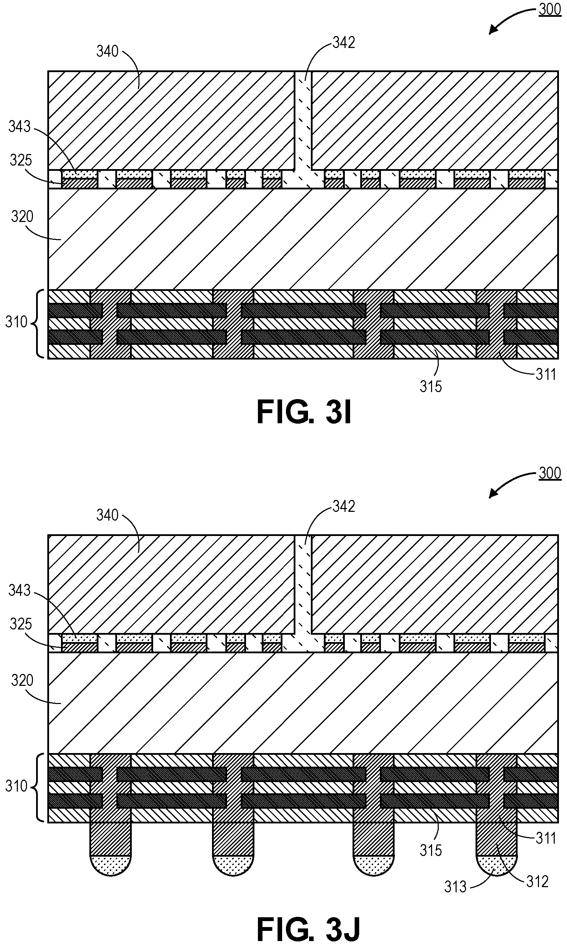

Referring now to Figure 3I, a cross-sectional illustration of the electronic system 300 after the carrier 302 is removed is shown, in accordance with an embodiment. In an embodiment, the carrier 302 may be released by exposing the release layer 303 to the necessary stimulus (e.g., IR radiation or UV radiation). After the release layer 303 and the carrier 302 are removed, the first layer 315 and the pads 311 are exposed.

Referring now to Figure 3J, a cross-sectional illustration of the electronic system 300 after interconnects are formed on the pads 311 is shown, in accordance with an embodiment. In an embodiment, the interconnects may comprise a bump 312, such as a copper bump 312, and a solder 313 on the bump 312.

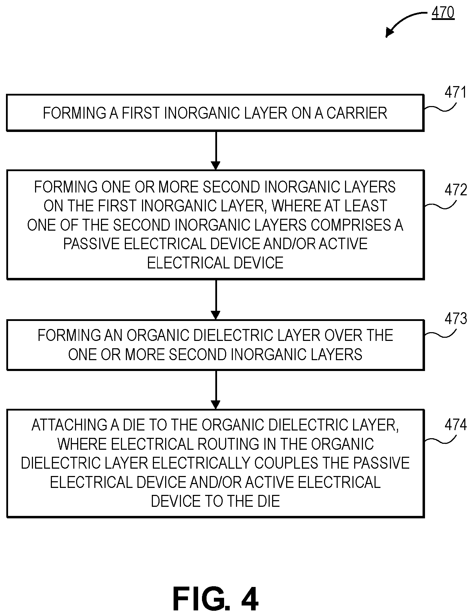

Referring now to Figure 4, a flow diagram of a process 470 for forming an electronic system with a hybrid interposer is shown, in accordance with an embodiment. The electronic system formed in process 470 may be similar to the electronic system 300 described in greater detail herein.

In an embodiment, the process 470 may begin with operation 471, which comprises forming a first inorganic layer on a carrier. In an embodiment, the process 470 may continue with operation 472, which comprises forming one or more second inorganic layers on the first inorganic layer. In an embodiment, at least one of the second inorganic layers may include a passive electrical device and/or an active electrical device. The passive electrical device and/or the active electrical device may be similar to any of the devices described in greater detail herein.

In an embodiment, the process 470 may continue with operation 473, which comprises forming an organic dielectric layer over the one or more second inorganic layers. The organic dielectric layer may comprise electrical routing for coupling to the one or more devices in the second layers. In an embodiment, the process 470 may continue with operation 474, which comprises attaching a die to the organic dielectric layer. In an embodiment, the electrical routing in the organic dielectric layer electrically couples the passive electrical device and/or the active electrical device to the die.

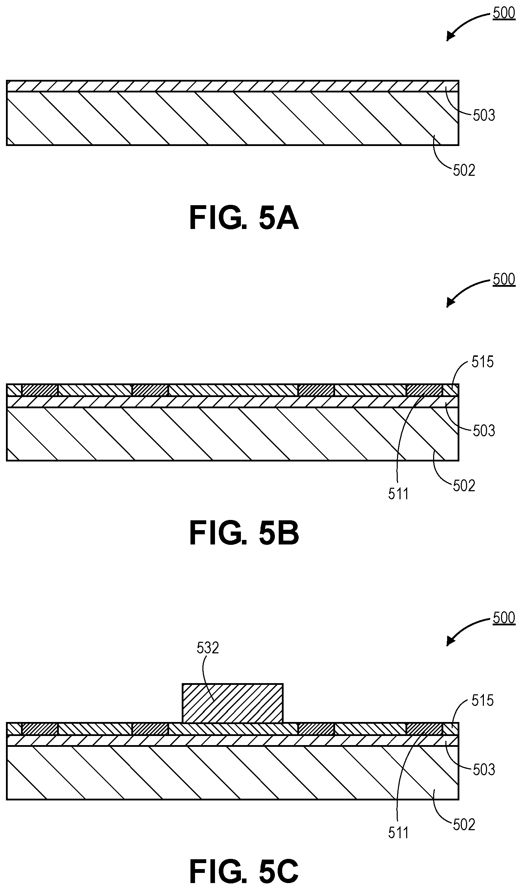

Referring now to Figures 5A - 5H, a series of cross-sectional illustrations depicting a process for forming an electronic system 500 is shown, in accordance with an embodiment. In an embodiment, the electronic system 500 in Figures 5A - 5H may be similar to the electronic system 200 shown in Figure 2B.

Referring now to Figure 5A, a cross-sectional illustration of the electronic system 500 at a stage of manufacture is shown, in accordance with an embodiment. As shown, the electronic system 500 comprises a carrier 502. The carrier 502 may be any material that is flat and rigid. For example, the carrier 502 may comprise silicon, glass, or the like. In an embodiment, a release layer 503 (or multiple release layers 503) are applied over the carrier 502. The release layer 503 may be deactivated (in order to release an overlying structure) by any suitable stimulus. The stimulus may include IR radiation, UV radiation, or the like.

Referring now to Figure 5B, a cross-sectional illustration of the electronic system 500 after a first layer 515 is formed over the release layer 503 is shown, in accordance with an embodiment. In an embodiment, the first layer 515 may comprise an inorganic dielectric material, such as any of those described in greater detail herein. In an embodiment, pads 511 may be formed into the first layer 515. The first layer 515 and the pads 511 may be formed with a damascene process, an SAP technique, or the like.

Referring now to Figure 5C, a cross-sectional illustration of the electronic system 500 after transfer layer 532 is applied over the first layer 515 is shown, in accordance with an embodiment. In an embodiment, the transfer layer 532 may comprise an inorganic dielectric material or a semiconductor material. In an embodiment, the transfer layer 532 may be applied to the first layer 515 with a selective layer transfer process. That is, the transfer layer 532 may be manufactured on a substrate, and the substrate is brought over the first layer 515. The transfer layer 532 is released from the substrate in order to be attached to the first layer 515. Due to the layer transfer process, the first layer 515 should be compatible with relatively high temperatures, which is at least one reason why an inorganic dielectric material is used for the first layer 515.

In an embodiment, the transfer layer 532 may include one or more devices (not shown) that are integrated into and/or provided on the transfer layer 532. The devices may include one or more active devices and/or one or more passive devices, such as any of those shown in greater detail herein. In a particular embodiment, the transfer layer 532 may comprise a plurality of MIM capacitors.

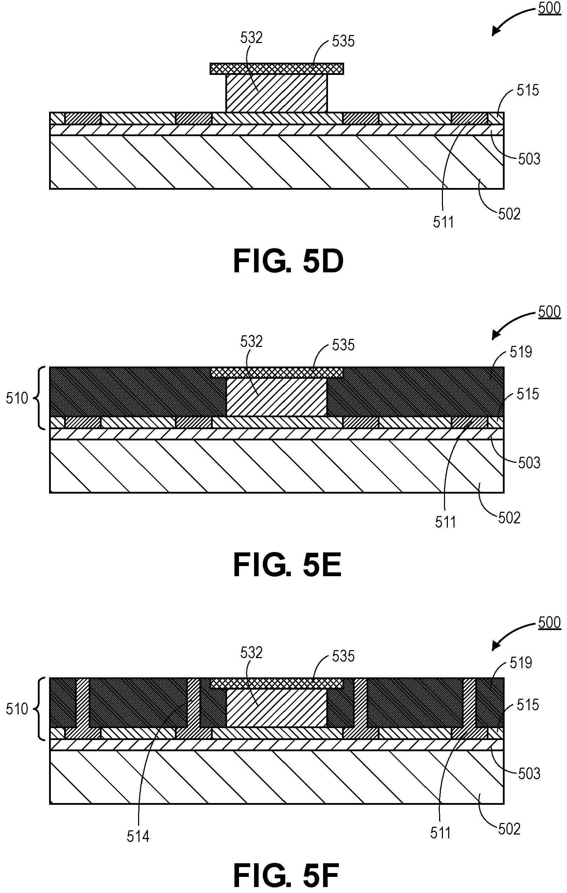

Referring now to Figure 5D, a cross-sectional illustration of the electronic system 500 after an additional layer 535 is applied over the transfer layer 532 is shown, in accordance with an embodiment. In an embodiment, the additional layer 535 may also be applied with a layer transfer process. The additional layer 535 may comprise an inorganic material, such as an inorganic dielectric or a semiconductor material. In some embodiments, the material of the transfer layer 532 is different than the material of the additional layer 535. Though, both the transfer layer 532 and the additional layer 535 may be the same material in some embodiments. The additional layer 535 may also comprise one or more active devices and/or one or more passive devices. In the illustrated embodiment, a width of the additional layer 535 is greater than a width of the transfer layer 532. Though, in other embodiments, the widths of the transfer layer 532 and the additional layer 535 may be substantially the same, or the width of the transfer layer 532 may be greater than a width of the additional layer 535.

Referring now to Figure 5E, a cross-sectional illustration of the electronic system 500 after a second layer 519 is applied over the first layer 515 is shown, in accordance with an embodiment. In an embodiment, the second layer 519 may comprise an organic material (e.g., a PID) or an inorganic dielectric material. The second layer 519 may be applied with any suitable deposition process. The second layer 519 may at least partially embed the transfer layer 532 and the additional layer 535. As shown in Figure 5E, the combination of the first layer 515, the second layer 519, the embedded transfer layer 532, and additional layer 535 may be referred to as the first strata 510.

Referring now to Figure 5F, a cross-sectional illustration of the electronic system 500 after vias 514 are formed through the second layer 519 is shown, in accordance with an embodiment. In an embodiment, the vias 514 may be formed by patterning openings in the second layer 519 and depositing (e.g., plating) copper in the openings.

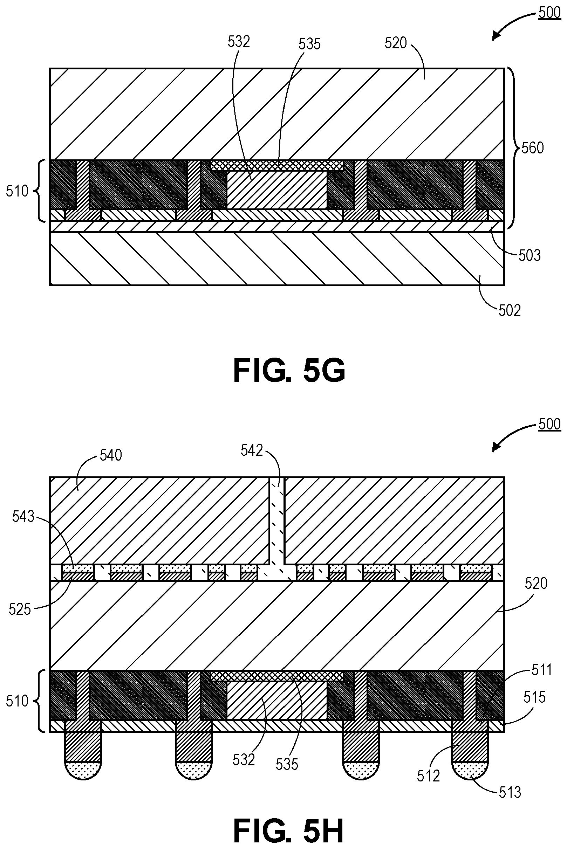

Referring now to Figure 5G, a cross-sectional illustration of the electronic system 500 after a second strata 520 is formed over the first strata 510 is shown, in accordance with an embodiment. In an embodiment, the second strata 520 may comprise organic dielectric material, such as any of the organic dielectric material described in greater detail herein. While shown as a single monolithic layer, it is to be appreciated that the second strata 520 may comprise a plurality of organic dielectric layers. Additionally, electrical routing (e.g., pads, traces, vias, etc.) may be provided in the second strata 520, similar to the embodiment shown in Figure 2B. As illustrated, the combination of the first strata 510 and the second strata 520 may be referred to as an interposer 560. More particularly, the interposer 560 may be a hybrid interposer 560.

Referring now to Figure 5H, a cross-sectional illustration of the electronic system 500 after one or more dies 540 are coupled to the second strata 520 by interconnects is shown, in accordance with an embodiment. In an embodiment, the interconnects may comprise pads 525 on the second strata 520 and solder 543 that is provided over the pads 525. Though, it is to be appreciated that other types of interconnect architectures may be used.

In an embodiment, the dies 540 may include any type of die, such as a processor, a memory, a communications die, and/or the like. In an embodiment, a mold layer 542 may be used to encapsulate the dies 540. While two dies 540 are shown in Figure 5H, it is to be appreciated that any number of dies may be coupled to the second strata 520. In an embodiment, the two dies 540 may be electrically coupled to each other by electrical routing (not shown) within the second strata 520, similar to the embodiment shown in Figure 2B.

In an embodiment, the carrier 502 is also removed in Figure 5H. In an embodiment, the carrier 502 may be released by exposing the release layer 503 to the necessary stimulus (e.g., IR radiation or UV radiation). After the release layer 503 and the carrier 502 are removed the first layer 515 and the pads 511 are exposed. In an embodiment, the interconnects are coupled to the pads 511 for connecting to an additional substrate (not shown). For example, the interconnects may comprise a bump 512, such as a copper bump 512, and a solder 513 on the bump 512.

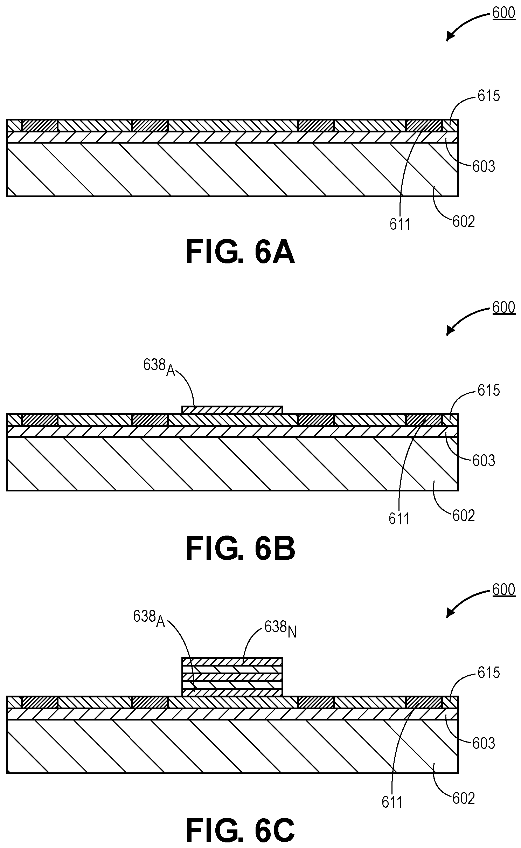

Referring now to Figures 6A - 6H, a series of cross-sectional illustrations depicting a process for forming an electronic system 600 is shown, in accordance with an embodiment. In an embodiment, the electronic system 600 in Figures 6A - 6H may be similar to the electronic system 200 shown in Figure 2C.

Referring now to Figure 6A, a cross-sectional illustration of the electronic system 600 after a first layer 615 is formed over a carrier 602 and adhesion layer 603 is shown, in accordance with an embodiment. In an embodiment, the carrier 602 may be any material that is flat and rigid. For example, the carrier 602 may comprise silicon, glass, or the like. In an embodiment, a release layer 603 (or multiple release layers 603) are applied over the carrier 602. The release layer 603 may be deactivated (in order to release an overlying structure) by any suitable stimulus. The stimulus may include IR radiation, UV radiation, or the like.

In an embodiment, the first layer 615 may comprise an inorganic dielectric material, such as any of those described in greater detail herein. In an embodiment, pads 611 may be formed into the first layer 615. The first layer 615 and the pads 611 may be formed with a damascene process, an SAP technique, or the like.

Referring now to Figure 6B, a cross-sectional illustration of the electronic system 600 after a first transfer layer 638_{A} is applied over the first layer 615 is shown, in accordance with an embodiment. In an embodiment, the first transfer layer 638_{A} may comprise an inorganic dielectric material or a semiconductor material. In an embodiment, the first transfer layer 638_{A} may be applied to the first layer 615 with a selective layer transfer process. That is, the first transfer layer 638_{A} may be manufactured on a substrate, and the substrate is brought over the first layer 615. The first transfer layer 638_{A} is released from the substrate in order to be attached to the first layer 615. Due to the layer transfer process, the first layer 615 should be compatible with relatively high temperatures, which is at least one reason why an inorganic dielectric material is used for the first layer 615.

In an embodiment, the first transfer layer 638_{A} may include one or more devices (not shown) that are integrated into and/or provided on the first transfer layer 638_{A}. The devices may include one or more active devices and/or one or more passive devices, such as any of those shown in greater detail herein. In a particular embodiment, the first transfer layer 638_{A} may comprise a plurality of MIM capacitors.

Referring now to Figure 6C, a cross-sectional illustration of the electronic system 600 after a plurality of transfer layer 638 are stacked over the first transfer layer 638_{A} is shown, in accordance with an embodiment. In an embodiment, any number of transfer layers 638_{A} - 638_{N} may be used in the electronic system 600. The additional transfer layers 638 may also be applied with a layer transfer process. One or more of the transfer layers 638_{A} - 638_{N} may each comprise devices, such as one or more active devices and/or one or more passive devices.

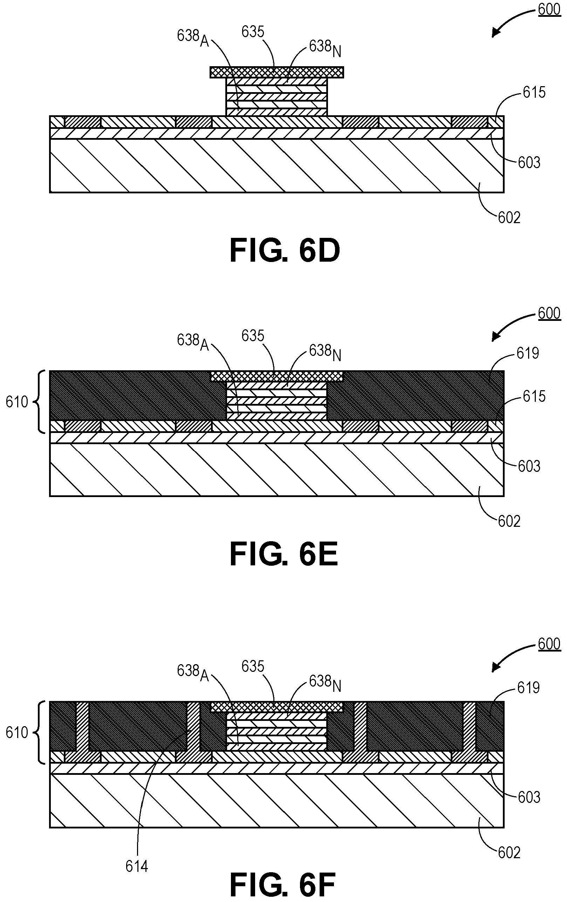

Referring now to Figure 6D, a cross-sectional illustration of the electronic system after an additional layer 635 is applied over the transfer layer 638_{N} is shown, in accordance with an embodiment. In an embodiment, the additional layer 635 may also be applied with a layer transfer process. The additional layer 635 may comprise an inorganic material, such as an inorganic dielectric or a semiconductor material. In some embodiments, the material of one or more of the transfer layers 638 is different than the material of the additional layer 635. Though, one or more of the transfer layers 638 and the additional layer 635 may be the same material in some embodiments. The additional layer 635 may also comprise one or more active devices and/or one or more passive devices. In the illustrated embodiment, a width of the additional layer 635 is greater than a width of the transfer layers 638. Though, in other embodiments, the widths of the transfer layers 638 and the additional layer 635 may be substantially the same, or the width of the transfer layers 638 may be greater than a width of the additional layer 635.

Referring now to Figure 6E, a cross-sectional illustration of the electronic system 600 after a second layer 619 is applied over the first layer 615 is shown, in accordance with an embodiment. In an embodiment, the second layer 619 may comprise an organic material (e.g., a PID) or an inorganic dielectric material. The second layer 619 may be applied with any suitable deposition process. The second layer 619 may at least partially embed the transfer layers 638 and the additional layer 635. As shown in Figure 6E, the combination of the first layer 615, the second layer 619, the embedded transfer layers 638, and additional layer 635 may be referred to as the first strata 610.

Referring now to Figure 6F, a cross-sectional illustration of the electronic system 600 after vias 614 are formed through the second layer 619 is shown, in accordance with an embodiment. In an embodiment, the vias 614 may be formed by patterning openings in the second layer 619 and depositing (e.g., plating) copper in the openings.

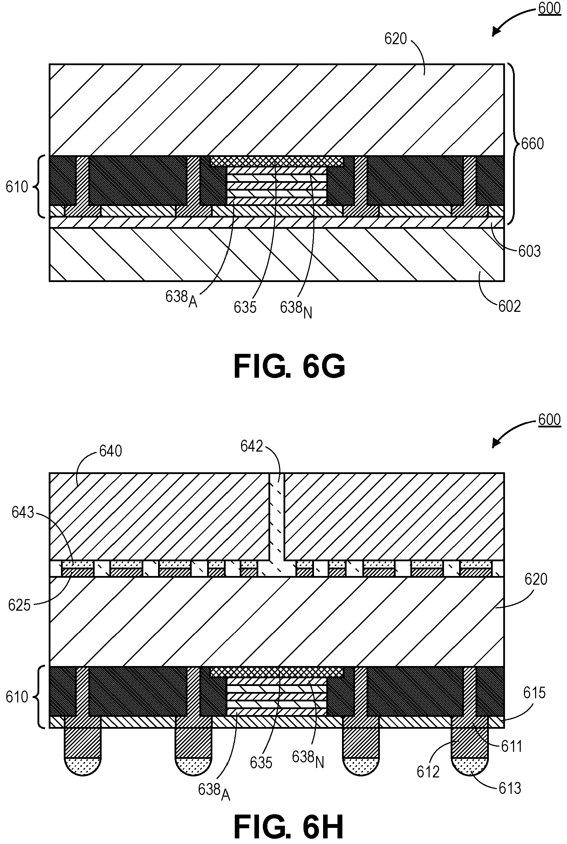

Referring now to Figure 6G, a cross-sectional illustration of the electronic system 600 after a second strata 620 is formed over the first strata 610 is shown, in accordance with an embodiment. In an embodiment, the second strata 620 may comprise organic dielectric material, such as any of the organic dielectric material described in greater detail herein. While shown as a single monolithic layer, it is to be appreciated that the second strata 620 may comprise a plurality of organic dielectric layers. Additionally, electrical routing (e.g., pads, traces, vias, etc.) may be provided in the second strata 620, similar to the embodiment shown in Figure 2C. As illustrated, the combination of the first strata 610 and the second strata 620 may be referred to as an interposer 660. More particularly, the interposer 660 may be a hybrid interposer 660.

Referring now to Figure 6H, a cross-sectional illustration of the electronic system 600 after one or more dies 640 are coupled to the second strata 620 by interconnects is shown, in accordance with an embodiment. In an embodiment, the interconnects may comprise pads 625 on the second strata 620 and solder 643 that is provided over the pads 625. Though, it is to be appreciated that other types of interconnect architectures may be used.

In an embodiment, the dies 640 may include any type of die, such as a processor, a memory, a communications die, and/or the like. In an embodiment, a mold layer 642 may be used to encapsulate the dies 640. While two dies 640 are shown in Figure 6H, it is to be appreciated that any number of dies may be coupled to the second strata 620. In an embodiment, the two dies 640 may be electrically coupled to each other by electrical routing (not shown) within the second strata 620, similar to the embodiment shown in Figure 2C.

In an embodiment, the carrier 602 is also removed in Figure 6H. In an embodiment, the carrier 602 may be released by exposing the release layer 603 to the necessary stimulus (e.g., IR radiation or UV radiation). After the release layer 603 and the carrier 602 are removed the first layer 615 and the pads 611 are exposed. In an embodiment, the interconnects are coupled to the pads 611 for connecting to an additional substrate (not shown). For example, the interconnects may comprise a bump 612, such as a copper bump 612, and a solder 613 on the bump 612.

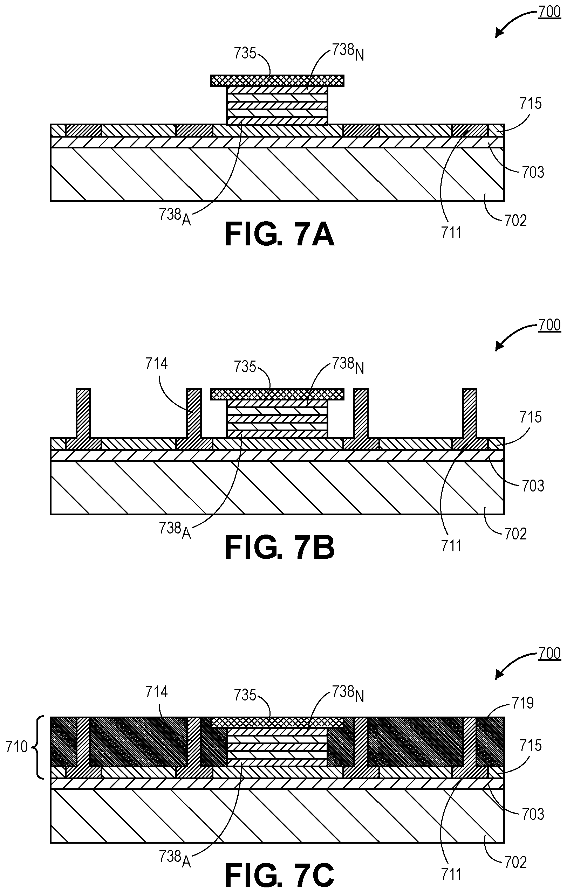

Referring now to Figures 7A - 7C, a series of cross-sectional illustrations that illustrate an alternative process for forming vias in the first strata 710 of an electronic system 700 is shown, in accordance with an embodiment. In Figures 7A - 7C, the vias 714 are formed with a via 714 first process before the second layer 719 is formed.

Referring now to Figure 7A, a cross-sectional illustration of an electronic system 700 at a stage of manufacture is shown, in accordance with an embodiment. The electronic system 700 may be manufactured with processes similar to those described above with respect to Figures 6A - 6D. For example, a first layer 715 with pads 711 is formed over a release layer 703 on a carrier 702. A plurality of transfer layers 738_{A} - 738_{N} may be provided on the first layer 715. An additional layer 735 may be provided over the plurality of transfer layers 738. While an embodiment similar to the electronic system 600 is shown, it is to be appreciated that a via first process may also be used with an embodiment that includes an electronic system that is similar to the electronic system 500.

Referring now to Figure 7B, a cross-sectional illustration of the electronic system 700 after vias 714 are formed over the first layer 715 is shown, in accordance with an embodiment. In an embodiment, the vias 714 may be plated up from the pads 711 with any suitable plating process or deposition process capable of forming free standing high aspect ratio features.

Referring now to Figure 7C, a cross-sectional illustration of the electronic system 700 after a second layer 719 is applied over the first layer 715 is shown, in accordance with an embodiment. Any suitable deposition process may be used to form the second layer 719. The second layer 719 may embed the vias 714, the transfer layers 738, and the additional layer 735. In an embodiment, the second layer 719 may comprise an inorganic dielectric or an organic dielectric. Subsequent processing to for an electronic system 700 with a hybrid interposer and attached dies may proceed with a process similar to any of the other embodiments described in greater detail herein.

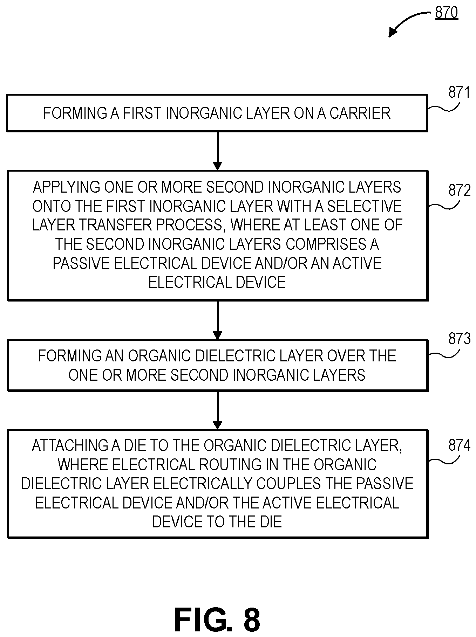

Referring now to Figure 8, a flow diagram of a process 870 for assembling an electronic system with a hybrid interposer is shown, in accordance with an embodiment. In an embodiment, the electronic system formed with the process 870 may be similar to the electronic system 500 or the electronic system 600 described in greater detail herein.

In an embodiment, the process 870 may begin with operation 871, which comprises forming a first inorganic layer on a carrier. In an embodiment, the process 870 may continue with operation 872, which comprises applying one or more second inorganic layers onto the first inorganic layer with a selective layer transfer process. In an embodiment, at least one of the second inorganic layers comprises a passive electrical device and/or an active electrical device. The passive electrical device and/or the active electrical device may be similar to any of the devices described in greater detail herein. In an embodiment, the second inorganic layers may comprise an inorganic dielectric material and/or a semiconductor material.

In an embodiment, the process 870 may continue with operation 873, which comprises forming an organic dielectric layer over the one or more second inorganic layers. The organic dielectric layer may comprise electrical routing for coupling to the one or more devices in the second layers. In an embodiment, the process 870 may continue with operation 874, which comprises attaching a die to the organic dielectric layer. In an embodiment, the electrical routing in the organic dielectric layer electrically couples the passive electrical device and/or the active electrical device to the die.

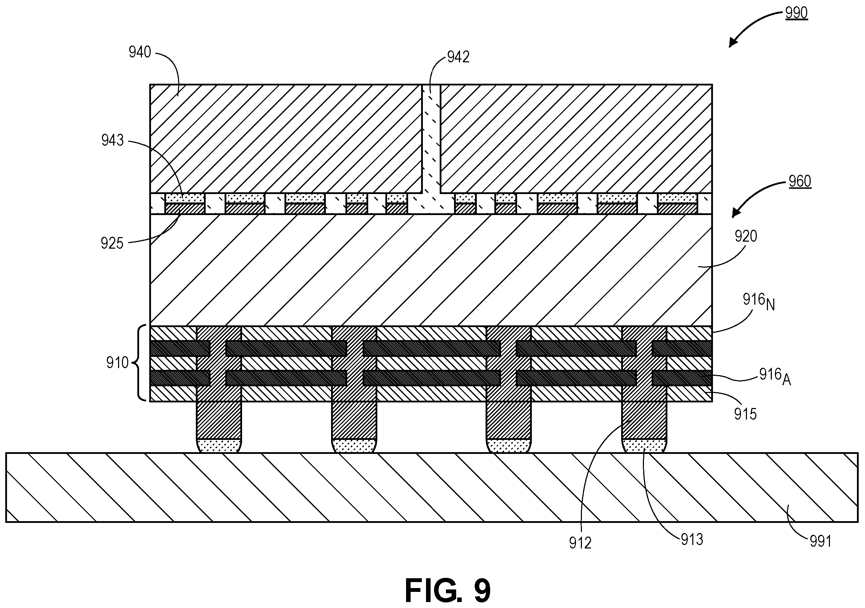

Referring now to Figure 9, a cross-sectional illustration of an electronic system 990 is shown, in accordance with an embodiment. In an embodiment, the electronic system 990 comprises a board 991, such as a printed circuit board (PCB), a mother board or the like. In an embodiment, the board 991 is coupled to an interposer 960 by interconnects. The interconnects may comprise a bump 912 and a solder 913. Though, any suitable SLI structure may be used to couple the interposer 960 to the board 991.

In an embodiment, the interposer 960 may be a hybrid interposer 960. For example, a first strata 910 may comprise an inorganic first layer 915 and a plurality of inorganic second layers 916_{A} - 916_{N}. In an embodiment, the first strata 910 in Figure 9 is similar to the first strata 210 in Figure 2A. Though, in other embodiments, the first strata 910 may be similar to any of the first strata described in greater detail herein. For example, one or more transfer layers and/or an additional layer over the one or more transfer layers may be provided in the first strata 910. In an embodiment, the first strata 910 may comprise one or more devices (not shown), such as any of the passive electrical devices and/or active electrical devices described in greater detail herein.

In an embodiment, the interposer 960 may also comprise a second strata 920 over the first strata 910. The second strata 920 may comprise one or more organic dielectric layers. The second strata 920 may also comprise electrical routing (e.g., pads, vias, traces, etc.) for electrically coupling components together and/or for providing die-to-die interconnects between dies 940 over the interposer 960.

In an embodiment, one or more dies 940 may be coupled to the interposer 960 through any suitable FLI architecture. For example, bumps 925 with solder 943 are shown in Figure 9. Though, hybrid bonding or any other suitable bonding architecture may also be used. In an embodiment, the dies 940 may be at least partially embedded in a mold layer 942.

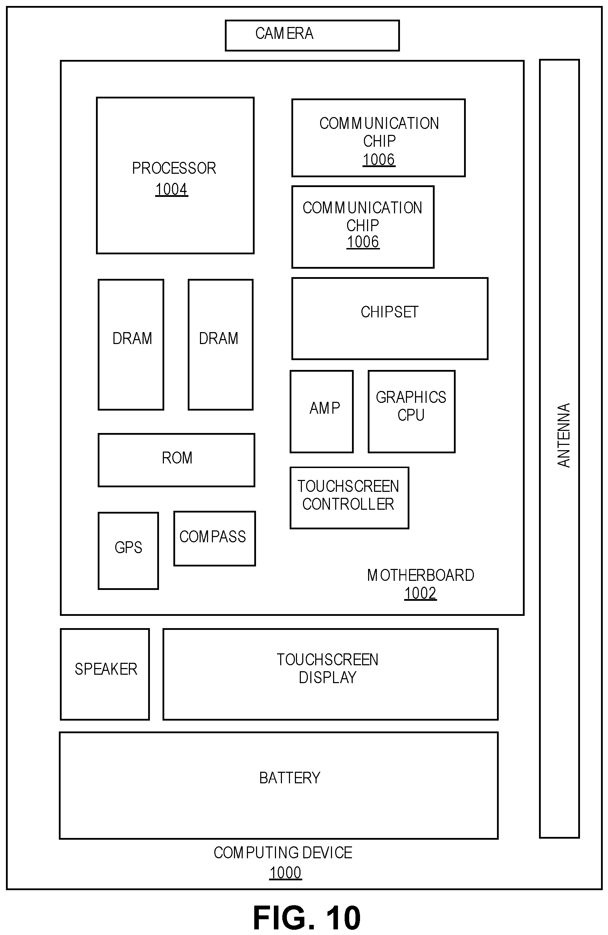

Figure 10 illustrates a computing device 1000 in accordance with one implementation of the disclosure. The computing device 1000 houses a board 1002. The board 1002 may include a number of components, including but not limited to a processor 1004 and at least one communication chip 1006. The processor 1004 is physically and electrically coupled to the board 1002. In some implementations the at least one communication chip 1006 is also physically and electrically coupled to the board 1002. In further implementations, the communication chip 1006 is part of the processor 1004.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1006 enables wireless communications for the transfer of data to and from the computing device 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing device 1000 includes an integrated circuit die packaged within the processor 1004. In some implementations of the disclosure, the integrated circuit die of the processor may be part of an electronic package that comprises a hybrid interposer with an inorganic strata and an organic strata, in accordance with embodiments described herein. The term "processor" may refer to any device or portion of a device that processes electronic data from registers and/or memory to transform that electronic data into other electronic data that may be stored in registers and/or memory.

The communication chip 1006 also includes an integrated circuit die packaged within the communication chip 1006. In accordance with another implementation of the disclosure, the integrated circuit die of the communication chip may be part of an electronic package that comprises a hybrid interposer with an inorganic strata and an organic strata, in accordance with embodiments described herein.

In an embodiment, the computing device 1000 may be part of any apparatus. For example, the computing device may be part of a personal computer, a server, a mobile device, a tablet, an automobile, or the like. That is, the computing device 1000 is not limited to being used for any particular type of system, and the computing device 1000 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a first layer, wherein the first layer is a first inorganic material; a second layer over the first layer, wherein the second layer is a second inorganic material, and wherein the second layer comprises an active electrical device or a passive electrical device; and a third layer over the second layer, wherein the third layer comprises an organic buildup film, and wherein the passive electrical device or the active electrical device is electrically coupled to one or more electrically conductive traces embedded in the third layer.

Example 2: the apparatus of Example 1, wherein the first layer has a first width and the second layer has a second width that is substantially equal to the first width.

Example 3: the apparatus of Example 1, wherein the first layer has a first width and the second layer has a second width that is smaller than the first width.

Example 4: the apparatus of Examples 1-3, wherein the second layer comprises a plurality of sub-layers, wherein the plurality of sub-layers include the second inorganic material, and wherein at least one of the plurality of sub-layers comprise the active electrical device or the passive electrical device.

Example 5: the apparatus of Examples 1-4, wherein the first inorganic material is the same as the second inorganic material.

Example 6: the apparatus of Examples 1-5, wherein the second inorganic material comprises a semiconductor material.

Example 7: the apparatus of Examples 1-6, wherein the first inorganic material and/or the second inorganic material comprises an inorganic dielectric material.

Example 8: the apparatus of Examples 1-7, further comprising: a via through a thickness of the second layer.

Example 9: the apparatus of Examples 1-8, further comprising: a die coupled to the third layer, and wherein the die is electrically coupled to the passive electrical device or the active electrical device by the one or more electrically conductive traces in the third layer.

Example 10: the apparatus of Examples 1-9, wherein the passive electrical device comprises a capacitor, an inductor, and/or a resistor.

Example 11: the apparatus of Examples 1-10, wherein the active electrical device comprises a transistor, a diode, a memory cell, and/or an RF circuit.

Example 12: an apparatus, comprising: a first strata, wherein the first strata comprises: a first layer, wherein the first layer comprises an inorganic dielectric material; a transfer layer over the first layer; and an electrical device within the transfer layer, wherein the electrical device comprises one or more of a capacitor, an inductor, a resistor, a transistor, or a diode; and a second strata over the first strata, wherein the second strata comprises: a second layer, wherein the second layer comprises an organic buildup film, and wherein the electrical device is electrically coupled to one or more electrically conductive traces embedded in the third layer.

Example 13: the apparatus of Example 12, wherein the transfer layer comprises the inorganic dielectric material.

Example 14: the apparatus of Example 13, wherein the electrical device is on a thin film layer comprising one or more of indium, gallium, zinc, or oxygen.

Example 15: the apparatus of Examples 12-13, wherein the transfer layer comprises a semiconductor material, and wherein the electrical device is on the semiconductor material.

Example 16: the apparatus of Examples 12-14, further comprising: a die electrically coupled to the second layer; and a board electrically coupled to the first strata.

Example 17: an apparatus, comprising: a plurality of first layers, wherein the plurality of first layers comprise an inorganic dielectric material; a plurality of second layers directly on the plurality of first layers, wherein the plurality of second layers comprise an organic dielectric material; an electrically passive device or an electrically active device embedded in at least one of the plurality of first layers; a die electrically coupled to the plurality of second layers; and electrically conductive routing embedded in the plurality of second layers, wherein the electrically passive device or the electrically active device is electrically coupled to the die by the electrically conductive routing.

Example 18: the apparatus of Example 17, wherein the electrically passive device is a metal-insulator-metal (MIM) capacitor integrated into one or more of the plurality of first layers.

Example 19: the apparatus of Example 17 or Example 18, wherein the electrically active device is on a semiconductor layer that is embedded within the plurality of first layers.

Example 20: the apparatus of Examples 17-19, further comprising: a via through at least one of the plurality of first layers, wherein the via is adjacent to the electrically passive device or the electrically active device.

## Claims

1. An apparatus, comprising:
a first layer, wherein the first layer is a first inorganic material;
a second layer over the first layer, wherein the second layer is a second inorganic material, and wherein the second layer comprises an active electrical device or a passive electrical device; and
a third layer over the second layer, wherein the third layer comprises an organic buildup film, and wherein the passive electrical device or the active electrical device is electrically coupled to one or more electrically conductive traces embedded in the third layer.

2. The apparatus of claim 1, wherein the first layer has a first width and the second layer has a second width that is substantially equal to the first width.

3. The apparatus of claim 1, wherein the first layer has a first width and the second layer has a second width that is smaller than the first width.

4. The apparatus of claim 1, 2 or 3, wherein the second layer comprises a plurality of sub-layers, wherein the plurality of sub-layers include the second inorganic material, and wherein at least one of the plurality of sub-layers comprise the active electrical device or the passive electrical device.

5. The apparatus of claim 1, 2, 3 or 4, wherein the first inorganic material is the same as the second inorganic material.

6. The apparatus of claim 1, 2, 3, 4 or 5, wherein the second inorganic material comprises a semiconductor material.

7. The apparatus of claim 1, 2, 3, 4, 5 or 6, wherein the first inorganic material and/or the second inorganic material comprises an inorganic dielectric material.

8. The apparatus of claim 1, 2, 3, 4, 5, 6 or 7, further comprising:
a via through a thickness of the second layer.

9. The apparatus of claim 1, 2, 3, 4, 5, 6, 7 or 8, further comprising:
a die coupled to the third layer, and wherein the die is electrically coupled to the passive electrical device or the active electrical device by the one or more electrically conductive traces in the third layer.

10. The apparatus of claim 1, 2, 3, 4, 5, 6, 7, 8 or 9, wherein the passive electrical device comprises a capacitor, an inductor, and/or a resistor.

11. The apparatus of claim 1, 2, 3, 4, 5, 6, 7, 8, 9 or 10, wherein the active electrical device comprises a transistor, a diode, a memory cell, and/or an RF circuit.

12. A method of fabricating an apparatus, the method comprising:
forming a first layer, wherein the first layer is a first inorganic material;
forming a second layer over the first layer, wherein the second layer is a second inorganic material, and wherein the second layer comprises an active electrical device or a passive electrical device; and
forming a third layer over the second layer, wherein the third layer comprises an organic buildup film, and wherein the passive electrical device or the active electrical device is electrically coupled to one or more electrically conductive traces embedded in the third layer.

13. The method of claim 12, wherein the first layer has a first width and the second layer has a second width that is substantially equal to the first width.

14. The method of claim 12, wherein the first layer has a first width and the second layer has a second width that is smaller than the first width.

15. The method of claim 12, 13 or 14, wherein the second layer comprises a plurality of sub-layers, wherein the plurality of sub-layers include the second inorganic material, and wherein at least one of the plurality of sub-layers comprise the active electrical device or the passive electrical device.
